# EUROPÄISCHE PATENTSCHRIFT

(11) **EP 2 981 833 B1**
(45) Veröffentlichungstag und Bekanntmachung des Hinweises auf die Patenterteilung: **25.01.2017**
(21) Anmeldenummer: 14705477.9
(22) Anmeldetag: 17.02.2014
(51) Int. Cl.: G01R 35/00, G01R 19/00, G01R 1/20

(54) **MESSWIDERSTAND UND ENTSPRECHENDES MESSVERFAHREN**
MEASURING RESISTOR AND CORRESPONDING MEASURING METHOD
RÉSISTANCE DE MESURE ET PROCÉDÉ DE MESURE CORRESPONDANT

(30) Priorität: 05.04.2013 DE 102013005939
(43) Veröffentlichungstag der Anmeldung: 10.02.2016
(60) Teilanmeldung: 16002093.9
(73) Patentinhaber: Isabellenhütte Heusler GmbH & Co. Kg, 35683 Dillenburg (DE)
(72) Erfinder: HETZLER, Ullrich, 35688 Dillenburg-Oberscheld (DE)
(74) Vertreter: v. Bezold & Partner Patentanwälte - PartG mbB
(86) Internationale Anmeldenummer: PCT/EP2014/000430
(87) Internationale Veröffentlichungsnummer: WO 2014/161624

(56) Entgegenhaltungen:
- GB-A- 2 434 252
- JP-A- 2009 244 065
- US-A1- 2007 177 318
- US-B1- 6 181 234

## Beschreibung

Die Erfindung betrifft eine Messanordnung, insbesondere mit einem niederohmigen Strommesswiderstand. Weiterhin betrifft die Erfindung ein entsprechendes Messverfahren.

Aus dem Stand der Technik (z.B. DE 42 43 349 A1) ist seit längerem die Strommessung mit niederohmigen Strommesswiderständen ("Shunts") gemäß der sogenannten Vierleitertechnik bekannt. Dabei wird der zu messende elektrische Strom in den niederohmigen Strommesswiderstand eingeleitet, wobei die Spannung gemessen wird, die über dem Widerstandselement des niederohmigen Strommesswiderstandes abfällt. Die gemessene elektrische Spannung ist dann entsprechend dem Ohmschen Gesetz ein Maß für den elektrischen Strom, der durch den Strommesswiderstand fließt.

Derartige Strommesswiderstände können beispielsweise plattenförmig ausgebildet sein, wie es beispielsweise in EP 0 605 800 A1 und DE 42 43 349 A1 beschrieben ist. Eine andere Bauform derartiger Strommesswiderstände als Koaxialwiderstand ist beispielsweise in WO 2007/068409 A1 und DE 10 2005 059 561 A1 beschrieben.

Die bekannten Strommesswiderstände sind jedoch hinsichtlich der Messgenauigkeit noch nicht vollständig befriedigend. Ferner ist zum Stand der Technik hinzuweisen auf US 6 181 234 B1. Diese Druckschrift offenbart einen plattenförmigen niederohmigen Widerstand mit einem mittig angeordneten Widerstandsstreifen, der beispielsweise aus einer Nickel-Aluminium-Legierung bestehen kann. An den beiden gegenüber liegenden Seitenkanten des Widerstandsstreifens sind zwei ebenfalls plattenförmige Wärmeleitelemente angeschweißt, die beispielsweise aus Kupfer bestehen können und ausschließlich zur Pufferung und Ableitung von Verlustwärme dienen. An der Oberseite des Wärmeleitelements sind hierbei fünf Kontaktpaare nebeneinander ausgeformt. Eines dieser Kontaktpaare dient hierbei zur Messung der über dem Widerstandsstreifen abfallenden elektrischen Spannung, während die anderen Kontaktpaare zum Einleiten bzw. Ausleiten des elektrischen Stroms dienen, was eine Strommessung gemäß der bekannten Vierleitertechnik ermöglicht. Auch hierbei erfolgt die Messung der über dem Widerstand abfallenden elektrischen Spannung nur an einer bestimmten Stelle mittels eines einzigen Kontaktpaars. Weiterhin ist hierbei zu erwähnen, dass die plattenförmigen Wärmeleitelemente an den Seiten des Widerstandsstreifens selbst nicht zur elektrischen Kontaktierung dienen und dazu auch nicht geeignet sind. Dieser bekannte Widerstand weist also einen grundsätzlich anderen Aufbau auf und ist deshalb gattungsfremd.

Weiterhin ist zum Stand der Technik noch hinzuweisen auf DE 10 2006 039 722 A1 und DE 10 2012 211 749 A1. Diese Druckschriften offenbaren jedoch andere Typen von Widerständen und sind deshalb ebenfalls gattungsfremd.

Aus US 2007/177318 A1 und JP 2009 244065 A ist eine Messanordnung gemäß dem Oberbegriff des Anspruchs 1 bekannt. Allerdings ist die Messgenauigkeit dieser bekannten Messanordnungen noch unbefriedigend.

Schließlich ist zum Stand der Technik noch hinzuweisen auf US 6 181 234 B1 und GB 2 434 252 A.

Der Erfindung liegt deshalb die Aufgabe zugrunde, eine verbesserte Messanordnung und ein verbessertes Messerfahren zu schaffen.

Diese Aufgabe wird durch eine erfindungsgemäße Messanordnung gemäß dem Hauptanspruch gelöst. Weiterhin umfasst die Erfindung ein entsprechendes Messverfahren gemäß dem Nebenanspruch.

Die Erfindung beruht auf der technisch-physikalischen Erkenntnis, dass die Stromdichte in dem Widerstandselement bei den bekannten Strommesswiderständen nicht exakt homogen und gleichgerichtet ist, so dass die Spannungsmesswerte an dem Messwiderstand von dem Ort der Messung abhängen, d.h. von der Positionierung der Spannungsmesskontakte. Beispielsweise werden diese störenden Inhomogenitäten der Stromdichte in dem Widerstandselement verursacht durch eine unsymmetrische Stromzuführung, Inhomogenitäten in Zuleitung, Anschlusskontakt und Widerstandsmaterial, Temperaturabhängigkeiten eines Kupfer-Vorwiderstands, Stromverdrängung und Einflüsse von Induktivität und Magnetfeldern. Bei der Berechnung des durch den Strommesswiderstand fließenden elektrischen Stroms entsprechend dem Ohmschen Gesetz aus dem Spannungsmesswert wird jedoch angenommen, dass der Spannungsmesswert exakt der Spannung entspricht, die über dem Widerstandselement des Strommesswiderstandes abfällt. Tatsächlich wird die Berechnung des durch den Strommesswiderstand fließenden elektrischen Stroms jedoch durch die vorstehend erwähnten Inhomogenitäten verfälscht.

Die Erfindung umfasst deshalb die allgemeine technische Lehre, die Inhomogenitäten der Stromdichte in dem Messwiderstand zu berücksichtigen und dadurch eine genauere Messung zu ermöglichen.

Der erfindungsgemäße Widerstand weist in Übereinstimmung mit dem eingangs beschriebenen herkömmlichen Strommesswiderstand vorzugsweise zwei Anschlussteile aus einem elektrisch leitfähigen Leitermaterial auf, um den elektrischen Strom in den Widerstand einzuleiten bzw. aus dem Widerstand abzuführen.

Bei dem Leitermaterial der beiden Anschlussteile handelt es sich vorzugsweise um Kupfer oder eine Kupferlegierung, da deren spezifischer elektrischer Widerstand äußerst gering ist. Die Erfindung ist jedoch hinsichtlich des Leitermaterials der Anschlussteile nicht auf Kupfer oder Kupferlegierungen beschränkt, sondern grundsätzlich auch mit anderen Leitermaterialien realisierbar, die einen hinreichend geringen spezifischen elektrischen Widerstand aufweisen. Vorzugsweise ist der spezifische elektrische Widerstand des Leitermaterials kleiner als 10⁻⁵ Ω·m, 10⁻⁶ Ω·m oder sogar kleiner als 10⁻⁷ Ω·m.

Darüber hinaus weist der erfindungsgemäße Widerstand in Übereinstimmung mit dem eingangs beschriebenen herkömmlichen Strommesswiderstand ein Widerstandselement auf, das im Stromflusspfad zwischen den beiden Anschlussteilen angeordnet ist, so dass der elektrische Strom durch das Widerstandselement fließt. Das Widerstandselement besteht hierbei aus einem niederohmigen Widerstandsmaterial, dessen spezifischer elektrischer Widerstand größer ist als der spezifische elektrische Widerstand des Leitermaterials der beiden Anschlussteile. Beispielsweise kann es sich bei dem Widerstandsmaterial des Widerstandselements um eine Nickellegierung handeln, wie beispielsweise Nickel-Chrom oder Kupfer-Nickel. Vorzugsweise wird als Widerstandsmaterial jedoch Cu84Ni4Mn12 (Manganin®) oder Cu91Mn7Sn2 (Zeranin® 30)eingesetzt.

Hierbei ist zu erwähnen, dass das Widerstandsmaterial vorzugsweise niederohmig ist und einen spezifischen elektrischen Widerstand aufweist, der vorzugsweise kleiner ist als 10⁻⁴ Ω·m, 10⁻⁵ Ω·m oder sogar kleiner als 10⁻⁶ Ω·m.

Ferner ist noch zu erwähnen, dass die Anschlussteile und/oder das Widerstandselement vorzugsweise plattenförmig sind, wobei auch eine gebogene Plattenform in Frage kommt, was an sich jedoch aus dem Stand der Technik bekannt ist.

Gemäß der Erfindung weist der Messwiderstand nicht nur ein einziges Paar von Spannungsmesskontakten auf, die mit den Anschlussteilen des Messwiderstands verbunden sind, um den Spannungsabfall über dem Widerstandselement des Messwiderstands zu messen. Vielmehr weist der erfindungsgemäße Messwiderstand mehrere Paare von Spannungsmesskontakten auf, wobei der eine Spannungsmesskontakt jedes Paars mit dem einen Anschlussteil verbunden ist, während der andere Spannungsmesskontakt jedes Paars das andere Anschlussteil kontaktiert. Die einzelnen Paare von Spannungsmesskontakten messen also jeweils den Spannungsabfall über dem Widerstandselement des Messwiderstands an unterschiedlichen räumlichen Positionen des Messwiderstands. Dadurch können die eingangs beschriebenen störenden Inhomogenitäten der Stromdichte messtechnisch kompensiert werden, indem die über dem Messwiderstand abfallende elektrische Spannung aus sämtlichen Spannungsmesswerten an den Paaren von Spannungsmesskontakten berechnet wird, beispielsweise durch eine einfache Mittelwertbildung.

Vorzugsweise sind die Paare von Spannungsmesskontakten hierbei bezüglich der Stromflussrichtung in dem Messwiderstand nebeneinander angeordnet. Bei einem plattenförmigen Messwiderstand, wie er beispielsweise aus EP 0 605 800 A1 bekannt ist, bedeutet dies, dass die einzelnen Paare von Spannungsmesskontakten quer zu dem Messwiderstand nebeneinander angeordnet sind. Bei einem Koaxialwiderstand, wie er beispielsweise aus WO 2007/068409 A1 bekannt ist, bedeutet dies dagegen vorzugsweise, dass die einzelnen Paare von Spannungsmesskontakten über den Umfang des Koaxialwiderstands verteilt angeordnet sind.

Die beiden vorstehend erwähnten Druckschriften EP 0 605 800 A1 und WO 2007/068409 A1 beschreiben jeweils einen plattenförmigen Messwiderstand bzw. einen Koaxialwiderstand, so dass auf eine detaillierte Beschreibung der konstruktiven Einzelheiten dieser Widerstandstypen verzichtet werden kann. Der Inhalt dieser Druckschriften ist deshalb der vorliegenden Beschreibung hinsichtlich des konstruktiven Aufbaus eines plattenförmigen Messwiderstands bzw. eines Koaxialwiderstands in vollem Umfang zuzurechnen.

Weiterhin ist zu erwähnen, dass die Paare der Spannungsmesskontakte vorzugsweise im Wesentlichen äquidistant verteilt angeordnet sind. Dies ist vorteilhaft, weil die Spannungsmesswerte dann ein aussagekräftiges Bild der räumlichen Stromdichteverteilung wiedergeben, so dass die Inhomogenitäten der Stromdichteverteilung messtechnisch gut kompensiert werden können.

Ferner ist zu erwähnen, dass die vorstehend erwähnten störenden Inhomogenitäten insbesondere dann relevant sind, wenn die Breite des Widerstandselements quer zur Stromflussrichtung relativ groß ist. Der erfindungsgemäße Messwiderstand ermöglicht jedoch aufgrund der Kompensation der störenden Inhomogenitäten relativ große Breiten von mehr als 5 mm, 10 mm, 20 mm, 5 mm, 100 mm oder sogar mehr als 200 mm.

Weiterhin ist zu erwähnen, dass die Anzahl der Paare von Spannungsmesskontakten vorzugsweise größer ist als 2, 4, 6 oder sogar 8, wobei eine große räumliche Dichte von Paaren von Spannungsmesskontakten eine gute messtechnische Kompensation der störenden Inhomogenitäten ermöglicht, da räumliche Schwankungen der Stromdichte in dem Messwiderstand dann besser abgebildet werden können.

Weiterhin ist zu erwähnen, dass Strom und Spannung in dem Widerstandselement des Messwiderstands teilweise ein induktives Verhalten und teilweise ein kapazitives Verhalten zeigen. Ein kapazitives Verhalten von Strom und Spannung zeichnet sich dadurch aus, dass der Strom bei einem Wechselstrom der Spannung vorauseilt. Ein induktives Verhalten zeichnet sich dagegen dadurch aus, dass der Strom bei einem Wechselstrom der Spannung nacheilt. Bei einem plattenförmigen Strommesswiderstand verhalten sich Strom und Spannung in den seitlich außen liegenden Bereichen des Widerstandselements in der Regel kapazitiv, während sich Strom und Spannung in einem mittleren Bereich des Widerstandselements im Wesentlichen induktiv verhalten. Zwischen den kapazitiven Bereichen und den induktiven Bereichen des Widerstandselements befinden sich neutrale Punkte, in denen Strom und Spannung im Wesentlichen phasengleich sind und somit weder ein kapazitives Verhalten noch ein induktives Verhalten zeigen. In einer Variante der Erfindung ist deshalb vorgesehen, dass ein Paar von Spannungsmesskontakten an dem Messwiderstand an einer Stelle angeordnet ist, die dem vorstehend erwähnten neutralen Punkt entspricht. Dies bedeutet, dass der Strom durch den Strommesswiderstand und die über dem Paar der Spannungsmesskontakte gemessene Spannung phasengleich sind.
Die Erfindung umfasst also eine komplette Messanordnung mit dem vorstehend beschriebenen erfindungsgemäßen Messwiderstand und einer Auswertungseinheit, die mit den Paaren von Spannungsmesskontakten verbunden ist und aus den Spannungsmesswerten die über dem Widerstandselement abfallende Spannung ermittelt, um daraus gemäß dem Ohmschen Gesetz den elektrischen Strom berechnen zu können, der durch den Messwiderstand fließt.

Ferner beansprucht die Erfindung auch Schutz für ein entsprechendes Messverfahren, wobei die Einzelheiten des Messverfahrens bereits aus der vorstehenden Beschreibung ersichtlich sind.

Ergänzend ist hierzu zu bemerken, dass die einzelnen Spannungsmesswerte an den verschiedenen Paaren von Spannungsmesskontakten jeweils mit einem Gewichtungsfaktor gewichtet werden, um dann aus den gewichteten Spannungsmesswerten die über dem Messwiderstand abfallende Spannung berechnen zu können. Vor der eigentlichen Messung werden diese Gewichtungsfaktoren vorzugsweise in einem separaten Kalibrierungsvorgang ermittelt.

Zu den Gewichtungsfaktoren ist zu bemerken, dass die störenden Inhomogenitäten des Stromverlaufs in dem Widerstandselement durch einen optimalen Satz von Gewichtungsfaktoren vollständig kompensiert werden können. Allerdings hängen die störenden Inhomogenitäten des Stromverlaufs in dem Widerstandselement auch von den aktuellen Messparametern (z.B. Temperatur, Frequenz, äußeres Magnetfeld, etc.) ab. Ein optimaler Satz von Gewichtungsfaktoren ermöglicht also nur für einen entsprechenden Satz von Messparametern eine optimale Kompensation der störenden Inhomogenitäten in dem Widerstandselement. In einem Ausführungsbeispiel der Erfindung ist deshalb vorgesehen, dass die Gewichtungsfaktoren nicht bauteilspezifisch konstant vorgegeben werden, sondern in Abhängigkeit von den aktuellen Messparametern bestimmt werden. Falls also beispielsweise die Messung unter einem äußeren Magnetfeld erfolgt, so werden andere Gewichtungsfaktoren ausgewählt als wenn die Messung ohne ein äußeres Magnetfeld erfolgt. Auf diese Weise ist es möglich, die störenden Inhomogenitäten des Stromverlaufs in dem Widerstandselement weitgehend unabhängig von den äußeren Messbedingungen (z.B. Temperatur, Frequenz, Magnetfeld) zu kompensieren, indem jeweils ein Satz von Gewichtungsfaktoren ausgewählt wird, der für die aktuellen Messbedingungen optimal geeignet ist. Der optimal geeignete Satz von Gewichtungsfaktoren wird hierbei vorzugsweise im Rahmen eines Kalibrierungsvorgangs bestimmt. Im Rahmen des Kalibrierungsvorgangs wird der Messwiderstand mit vorgegebenen, bekannten Strömen bestromt, wobei jeweils die Spannungsmesswerte über den Spannungsmesskontakten gemessen werden. Hierbei werden die Messparameter (z.B. Temperatur, Frequenz, Magnetfeld) für jeden Wert der Bestromung gemessen. Auf diese Weise kann dann für jeden Betriebspunkt ein optimaler Satz von Gewichtungsfaktoren ermittelt werden. Die so ermittelten Gewichtungsfaktoren für die verschiedenen Messparameter können dann in einem mehrdimensionalen Kennfeld gespeichert und dann während des eigentlichen Messbetriebs einfach ausgelesen werden.

Es ist jedoch alternativ auch möglich, dass die optimalen Gewichtungsfaktoren nicht aus einem Kennfeld ausgelesen, sondern in Abhängigkeit von den aktuellen Messparametern analytisch bestimmt werden.

Weiterhin ist zu erwähnen, dass die einzelnen Spannungsmesswerte vorzugsweise synchron gemessen werden. Durch diese synchrone und parallele Messung einer Vielzahl von Spannungsmesswerten wird auch das Rauschen stark reduziert, was bei den meist sehr kleinen Spannungsmesswerten ein großer Vorteil ist, da hiermit die Messauflösung gesteigert werden kann.

Darüber hinaus erfolgt die Messung der einzelnen Spannungsmesswerte vorzugsweise mit einer sehr hohen Abtastrate von beispielsweise mehr als 100 Hz, 500 Hz, 1 kHz, 2 kHz oder sogar mehr als 4 kHz.

In einem bevorzugten Ausführungsbeispiel der Erfindung wird ein Mittelwert der Spannungsmesswerte an den einzelnen Paaren von Spannungsmesskontakten berechnet, wobei die einzelnen Spannungsmesswerte auch unterschiedlich gewichtet werden können.

Diese Mittelwertbildung kann wahlweise auf der Grundlage der analogen Spannungsmesswerte oder auf der Grundlage von entsprechend digitalisierten Spannungsmesswerten erfolgen.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine schematische Perspektivansicht eines erfindungsgemäßen Strommesswiderstandes mit einer Vielzahl von Spannungsmesskontakten,
- Figur 2: eine schematische Darstellung eines Schaltbilds für eine analoge Mittelwertbildung aus den einzelnen Spannungsmesswerten an den Spannungsmesskontakten des Strommesswiderstandes gemäß Figur 1,
- Figur 3: ein Diagramm zur Verdeutlichung der unterschiedlichen Stromwerte, die aus den verschiedenen Spannungsmesswerten entsprechend dem Ohmschen Gesetz resultieren,
- Figur 4: ein Diagramm zur Verdeutlichung von Amplitude und Phasenverschiebung an den verschiedenen Spannungsmesskontakten in Abhängigkeit von der räumlichen Lage der Spannungsmesskontakte,
- Figur 5: ein Diagramm zur Verdeutlichung des kapazitiven Verhaltens von Strom und Spannung in den äußeren Bereichen des Strommesswiderstandes,
- Figur 6: ein Diagramm zur Verdeutlichung des induktiven Verhaltens im mittleren Bereich des Strommesswiderstandes,
- Figur 7: ein Diagramm zur Verdeutlichung der Störung der Messung durch ein externes Magnetfeld,
- Figur 8: eine perspektivische Teilansicht eines Koaxialwiderstands mit einer Vielzahl von Spannungsmesskontakten,
- Figur 9: ein nicht erfindungsgemäßes Ausführungsbeispiel eines plattenförmigen Strommesswiderstandes mit nur einem Paar von Spannungsmesskontakten,
- Figur 10: ein Flussdiagram zur Verdeutlichung des Kalibrierungsvorgangs zur Bestimmung der optimalen Gewichtungsfaktoren für verschiedene Messbedingungen, sowie
- Figur 11: ein Flussdiagramm zur Verdeutlichung des eigentlichen Messverfahrens für verschiedene Messbedingungen.

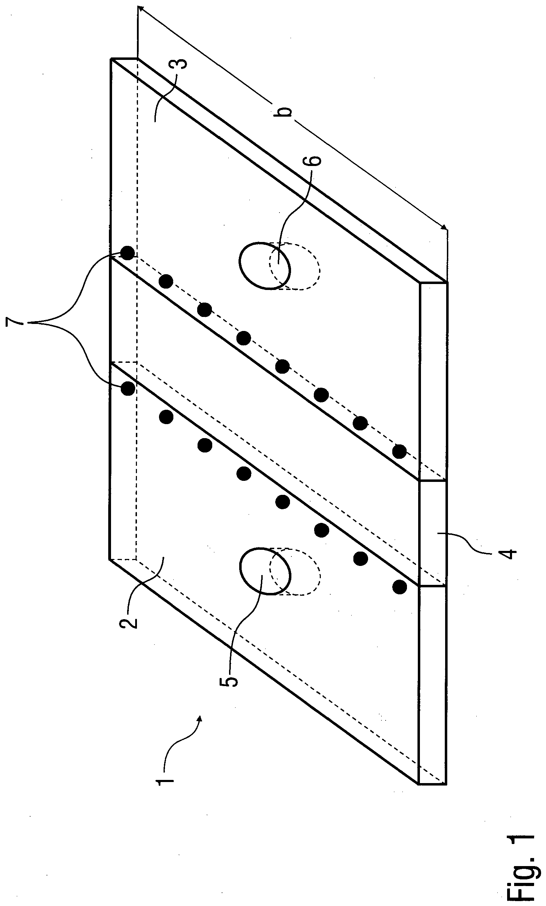

Figur 1 zeigt einen plattenförmigen Strommesswiderstand 1 zur Strommessung entsprechend der bekannten Vierleitertechnik.

Der Strommesswiderstand 1 ist weitgehend herkömmlich aufgebaut, so dass ergänzend auf die Patentanmeldung EP 0 605 800 A1 verwiesen wird, deren Inhalt der vorliegenden Beschreibung deshalb in vollem Umfang zuzurechnen ist.

Der Strommesswiderstand 1 besteht im Wesentlichen aus zwei plattenförmigen Anschlussteilen aus einem Leitermaterial (z.B. Kupfer oder eine Kupferlegierung) und einem ebenfalls plattenförmigen Widerstandselement 4 aus einem niederohmigen Widerstandsmaterial (z.B. Manganin®). Der zu messende elektrische Strom wird hierbei in das Anschlussteil 2 eingeleitet, fließt dann durch das Widerstandselement 4 und verlässt den Strommesswiderstand dann über das andere Anschlussteil 3.

Zum Einleiten bzw. Ausleiten des elektrischen Stroms weisen die Anschlussteile 2, 3 jeweils eine oder mehrere Bohrungen 5, 6 auf, an denen beispielsweise Anschlusskontakte festgeschraubt werden können.

In diesem Ausführungsbeispiel weist der Strommesswiderstand 1 eine Breite b = 200 mm auf, jedoch sind auch andere Werte für die Breite b des Strommesswiderstandes 1 möglich.

Problematisch hierbei ist die Tatsache, dass die Stromdichte in dem Widerstandselement 4 nicht exakt homogen und gleichgerichtet ist, sondern über die Breite b des Strommesswiderstandes 1 schwankt, was bei den herkömmlichen Messwiderständen zu entsprechenden Messfehlern führt, da die über dem Widerstandselement 4 abfallende Spannung hierbei nur durch zwei Spannungsmesskontakte gemessen wird.

Der erfindungsgemäße Strommesswiderstand 1 weist deshalb eine Vielzahl von Paaren von Spannungsmesskontakten 7 auf, die über die Breite b des Strommesswiderstandes 1 verteilt angeordnet sind. Bei jedem der Paare der Spannungsmesskontakte 7 ist einer der Spannungsmesskontakte 7 an dem Anschlussteil 2 angebracht, während der andere Spannungsmesskontakt 7 eines jeden Paares das andere Anschlussteil 3 kontaktiert. Die einzelnen Paare von Spannungsmesskontakten 7 messen also jeweils die über dem Widerstandselement 4 abfallende elektrische Spannung an verschiedenen Stellen entlang der Breite b des Strommesswiderstandes 1.

Bei einer Messung werden dann gleichzeitig zahlreiche Spannungsmesswerte an den Spannungsmesskontakten 7 gemessen, aus denen dann beispielsweise durch eine gewichtete Mittelwertbildung ein Spannungswert abgeleitet werden kann, der von den vorstehend beschriebenen störenden Inhomogenitäten der Stromdichte in dem Widerstandselement 4 befreit ist und deshalb eine größere Genauigkeit aufweist.

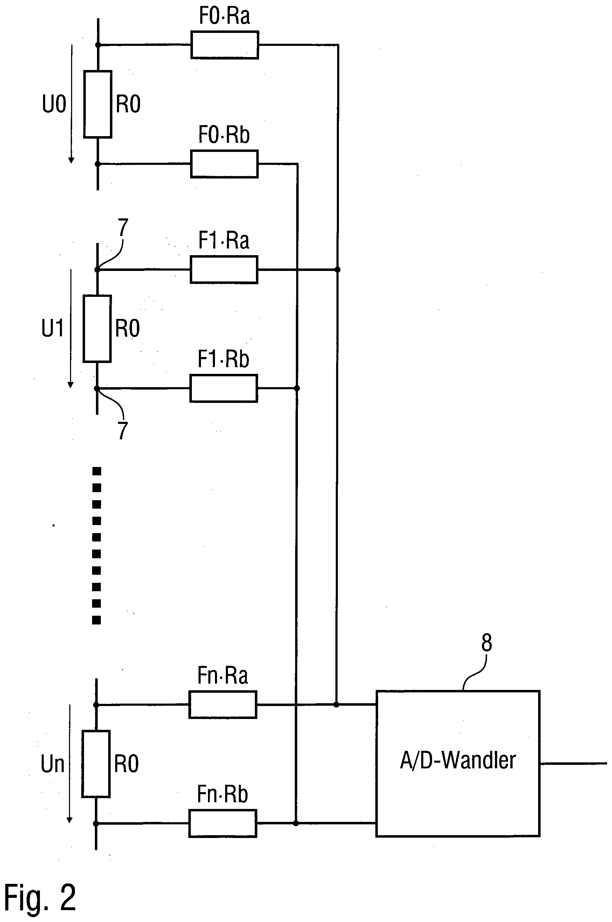

Figur 2 zeigt in stark vereinfachter schematischer Darstellung ein Schaltbild zur Verdeutlichung einer analogen Mittelwertbildung aus den Spannungsmesswerten, die bei dem Strommesswiderstand 1 gemäß Figur 1 an den verschiedenen Paaren von Spannungsmesskontakten 7 gemessen werden.

Hierzu werden an dem Strommesswiderstand 1 an den verschiedenen Paaren von Spannungsmesskontakten 7 jeweils Spannungsmesswerte U0, U1,..., Un gemessen, wobei die Spannungsmesswerte U0, U1, ..., Un jeweils über einem effektiven Widerstand R0, R1, ..., Rn abfallen.

Die Spannungsmesswerte U0, U1, ..., Un werden dann über unterschiedlich gewichtete Widerstände F0·Ra, F0·Rb, F1·Ra, F1·Rb, ..., Fn·Ra, Fn·Rb an den Eingang eines analogen Mess-Systems oder eines Analog/Digital-Wandlers 8 geführt, der dann ein entsprechendes Ausgangssignal ausgibt, das die über dem Widerstandselement 4 abfallende elektrische Spannung wiedergibt und von den vorstehend beschriebenen störenden Inhomogenitäten nahezu vollständig befreit ist.

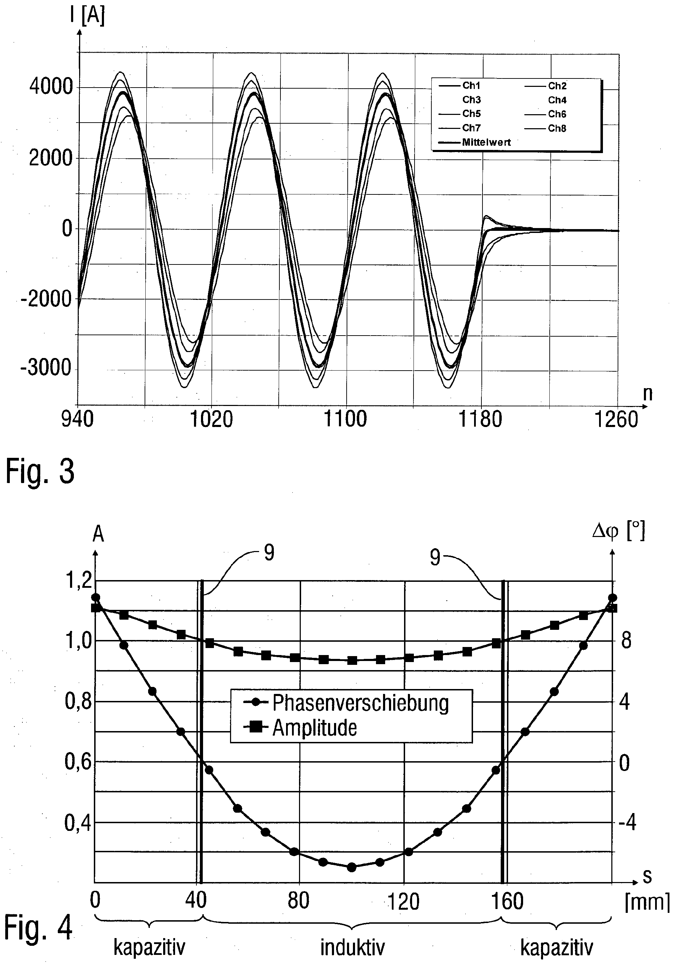

Figur 3 zeigt Messergebnisse an dem erfindungsgemäßen Strommesswiderstand 1 mit einem Widerstandswert von R = 1 µΩ und einer Breite b = 200 mm und acht Paaren von Spannungsmesskontakten 7. Hierbei beträgt der zugeführte elektrische Strom I = 4 kA.

Aus dem Diagramm ist ersichtlich, dass die einzelnen Spannungsmesswerte an den verschiedenen Paaren von Spannungsmesskontakten 7 sowohl hinsichtlich der Amplitude als auch hinsichtlich der Phasenlage geringfügig abweichen.

Figur 4 zeigt ein weiteres Diagramm zur Verdeutlichung der Abhängigkeit der Amplitude und der Phasenverschiebung in Abhängigkeit von der Messposition der Spannungsmesskontakte 7 innerhalb des Strommesswiderstandes 1.

Die X-Achse zeigt hierbei den Abstand des jeweiligen Spannungsmesskontakts 7 von der Seitenkante des Strommesswiderstandes 1.

Die Y-Achse zeigt dagegen zum einen die normierte Amplitude des Spannungsmesswerts und zum anderen die Phasenverschiebung in Grad.

Aus dem Diagramm ist ersichtlich, dass Strom und Spannung in der Mitte des Strommesswiderstandes 1 ein induktives Verhalten zeigen, wohingegen Strom und Spannung in den seitlichen Randbereichen des Strommesswiderstandes ein kapazitives Verhalten zeigen. Zwischen dem induktiven Mittelbereich des Strommesswiderstandes 1 und den kapazitiven Seitenbereichen des Strommesswiderstandes 1 befindet sich ein sogenannter neutraler Punkt 9, wobei es sich eigentlich um eine Linie entlang der Hauptstromflussrichtung in dem Strommesswiderstand 1 handelt. Bei einer Anordnung eines Paars von Spannungsmesskontakten 7 an dem neutralen Punkt 9 zeigen die Spannungsmesswerte und der elektrische Strom weder ein kapazitives noch ein induktives Verhalten, sondern sind im Wesentlichen phasengleich.

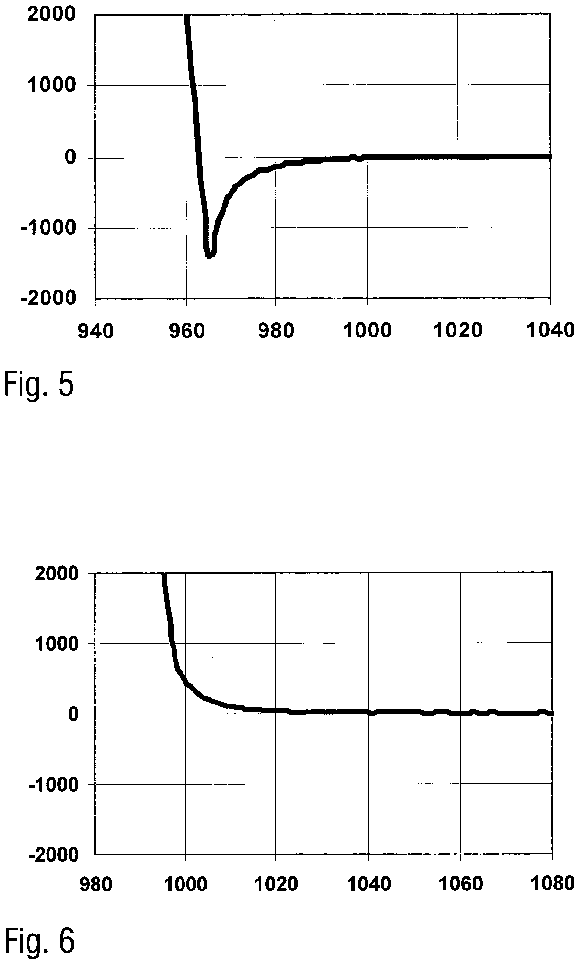

Figur 5 zeigt das kapazitive Verhalten von Strom und Spannung in den seitlichen Außenbereichen des Strommesswiderstandes 1 bei einem Abschaltvorgang. Aus dem Diagramm ist ersichtlich, dass bei positiver Phasenverschiebung ein Überschwinger auftritt.

Figur 6 zeigt das induktive Verhalten von Strom und Spannung in dem mittleren Bereich des Strommesswiderstandes 1 bei einem Abschaltvorgang. Aus dem Diagramm ist das asymptotische Auslaufen des Messsignals ersichtlich.

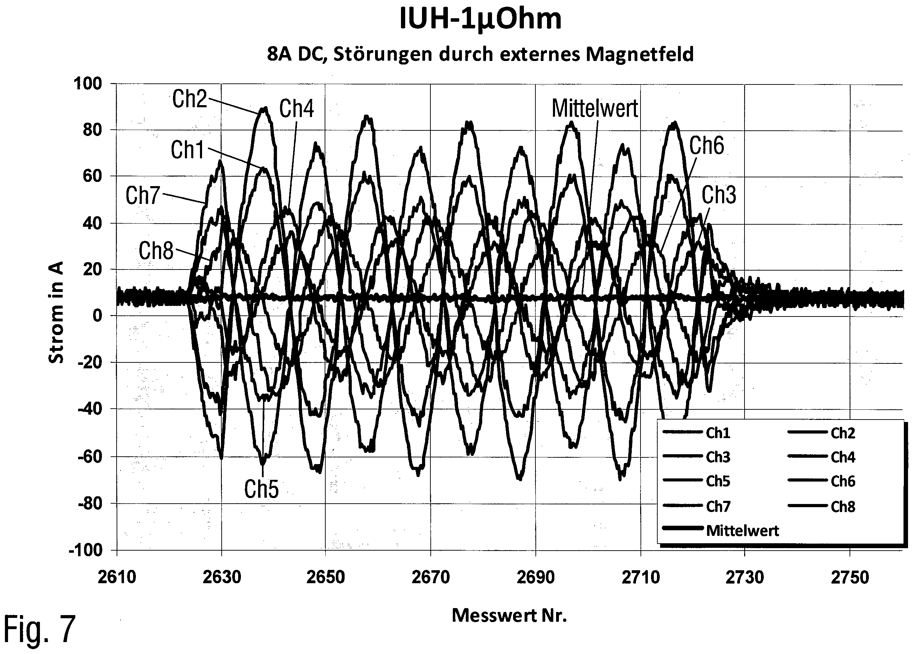

Ferner zeigt Figur 7 die Spannungsmesswerte an den verschiedenen Paaren von Spannungsmesskontakten 7 bzw. die daraus resultierenden entsprechenden Stromwerte bei einem Gleichstrom von ca. I = 8 A und einem in unmittelbarer Nähe des Strommesswiderstandes 1 verlaufenden Wechselstromkabel mit ca. I = 5000 A. Das in dem Wechselstromkabel entstehende Magnetfeld verursacht in dem Strommesswiderstand 1 und in dessen Zuleitungen Wirbelströme, die in den einzelnen Kanälen bzw. in den einzelnen Paaren der Spannungsmesskontakte 7 mit unterschiedlicher Phase und Amplitude gemessen werden, aber im gewichteten Mittel nicht sichtbar sind. Die Mittelwertbildung aus den verschiedenen Spannungsmesswerten ermöglicht also vorteilhaft auch eine Kompensation der störenden Einflüsse externer Magnetfelder.

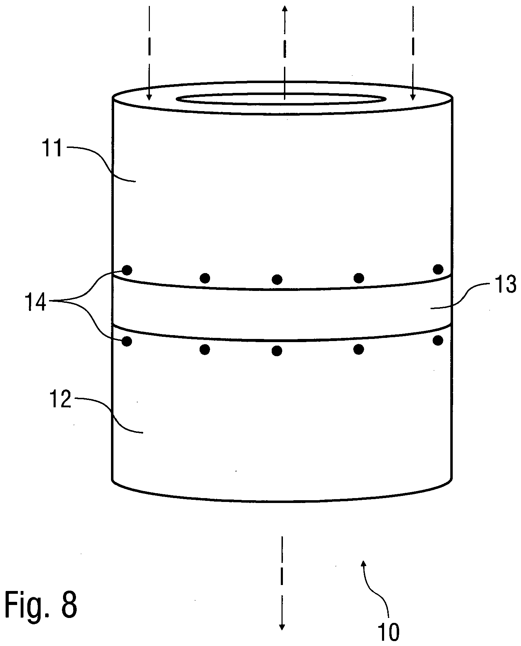

Figur 8 zeigt eine Teildarstellung eines Koaxialwiderstandes 10, wie er als Ganzes beispielsweise in WO 2007/068409 A1 beschrieben ist, so dass auf eine vollständige Beschreibung des Aufbaus und der Funktionsweise eines Koaxialwiderstands 10 verzichtet werden kann. Die bereits vorstehend zitierte Patentanmeldung WO 2007/068409 A1 ist deshalb hinsichtlich des Aufbaus und der Funktionsweise des Koaxialwiderstands 10 der vorliegenden Beschreibung in vollem Umfang zuzurechnen.

An dieser Stelle ist lediglich zu erwähnen, dass der Koaxialwiderstand 10 zwei ringförmige Anschlussteile 11, 12 aufweist, zwischen die ein ebenfalls ringförmiges Widerstandselement 13 eingesetzt ist.

Darüber hinaus weist der Koaxialwiderstand 10 zahlreiche Paare von Spannungsmesskontakten 14 auf, die über den Umfang verteilt sind und deshalb Inhomogenitäten der Stromverteilung entlang dem Umfang kompensieren können, wie an sich bereits aus der vorstehenden Beschreibung ersichtlich ist.

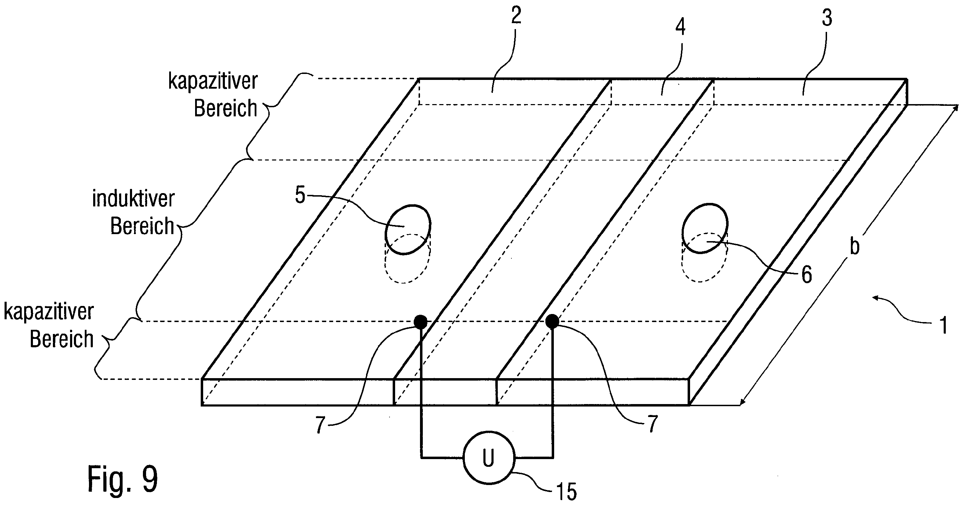

Figur 9 zeigt eine andere Variante eines nicht erfindungsgemäßen Strommesswiderstandes 1, der im Wesentlichen dem Strommesswiderstand 1 gemäß Figur 1 entspricht, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass der Strommesswiderstand 1 nur ein einziges Paar von Spannungsmesskontakten 7 aufweist, die jedoch zur Vermeidung von störenden Einflüssen der Inhomogenitäten der Stromverteilung in dem Widerstandselement 4 im Bereich des neutralen Punkts 9 angeordnet sind, d.h. exakt an der Grenze zwischen dem kapazitiven Bereich und dem induktiven Bereich des Strommesswiderstandes 1. Bei einer Messung eines Spannungsmesswerts an den Spannungsmesskontakten 7 mittels einer Auswertungseinheit 15 zeigen Strom und Spannung also weder ein induktives Verhalten noch ein kapazitives Verhalten, sondern sind im Wesentlichen phasengleich.

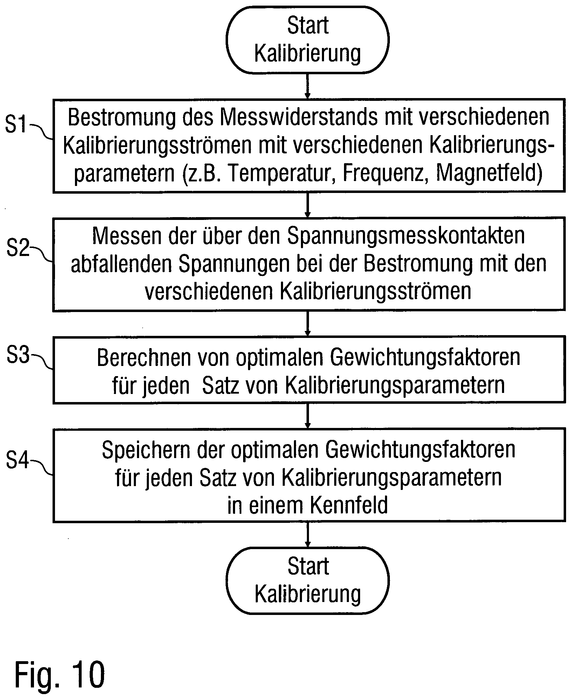

Figur 10 zeigt ein Flussdiagramm zur Verdeutlichung eines Kalibrierungsvorgangs zur Bestimmung der optimalen Gewichtungsfaktoren für verschiedene Messbedingungen.

In einem ersten Schritt S1 wird der Strommesswiderstand mit verschiedenen, bekannten Kalibrierungsströmen bestromt, wobei jeweils unterschiedliche Kalibrierungsparameter (z.B. Temperatur, Frequenz, Magnetfeld) herrschen. Die aktuellen Werte der Kalibrierungsparameter bestimmen also jeweils einen mehrdimensionalen Betriebspunkt, wobei der Betriebspunkt die störenden Inhomogenitäten in dem Widerstandselement beeinflusst. Bei der Bestromung des Strommesswiderstandes mit den verschiedenen Kalibrierungsströmen werden dann jeweils die über den Spannungsmesskontakten abfallenden Spannungen gemessen.

In einem Schritt S3 wird dann jeweils ein optimaler Satz von Gewichtungsfaktoren für jeden Betriebspunkt, d.h. für jeden Satz von Kalibrierungsparametern, berechnet.

Die so berechneten optimalen Sätze von Gewichtungsfaktoren werden dann in einem Schritt S4 in einem mehrdimensionalen Kennfeld abgespeichert.

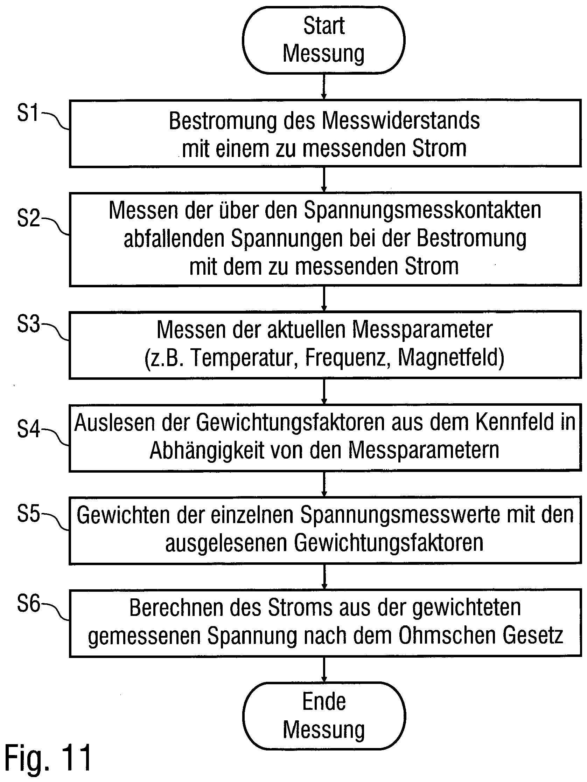

Figur 11 zeigt ein Flussdiagramm zur Verdeutlichung des eigentlichen Messverfahrens auf der Grundlage der vorstehend beschriebenen Kalibrierung.

In einem Schritt S1 wird der Messwiderstand mit einem zu messenden Strom bestromt.

In einem Schritt S2 werden dabei die über den Spannungsmesskontakten abfallenden Spannungen gemessen, während der Messwiderstand mit dem zu messenden Strom bestromt wird.

Darüber hinaus werden während der Bestromung die aktuellen Messparameter (z.B. Temperatur, Frequenz, Magnetfeld) gemessen, da diese Messparameter einen Einfluss auf die störenden Inhomogenitäten in dem Widerstandselement des Strommesswiderstandes haben können.

In Abhängigkeit von den aktuellen Messparametern wird dann in einem Schritt S4 ein passender Satz von Gewichtungsfaktoren aus dem Kennfeld ausgelesen, wobei die Gewichtungsfaktoren zuvor in dem Kalibrierungsverfahren gemäß Figur 10 ermittelt worden sind.

Die gemessenen Spannungsmesswerte werden dann in einem Schritt S5 mit den ausgelesenen Gewichtungsfaktoren gewichtet, um einen Spannungsmesswert zu ermittelt.

Schließlich wird dann in einem Schritt S6 aus dem gewichteten Spannungsmesswert gemäß dem Ohmschen Gesetz der Strom berechnet.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen. Insbesondere beansprucht die Erfindung auch Schutz für den Gegenstand und die Merkmale der Unteransprüche unabhängig von den jeweils in Bezug genommenen Ansprüchen.

### Bezugszeichenliste:

- 1: Strommesswiderstand
- 2: Anschlussteil
- 3: Anschlussteil
- 4: Widerstandselement
- 5: Bohrung
- 6: Bohrung
- 7: Spannungsmesskontakte
- 8: Analog/Digital-Wandler
- 9: Neutraler Punkt
- 10: Koaxialwiderstand
- 11: Anschlussteil
- 12: Anschlussteil
- 13: Widertandselement
- 14: Spannungsmesskontakte
- 15: Auswertungseinheit
- b: Breite des Strommesswiderstands

## Patentansprüche

1. Messanordnung mit
a) einem Messwiderstand (1; 10), mit
a1) einem ersten Anschlussteil (2) aus einem Leitermaterial zum Einleiten eines Stroms in den Messwiderstand (1; 10),
a2) einem zweiten Anschlussteil (3) aus dem Leitermaterial zum Ausleiten des Stroms aus dem Messwiderstand (1; 10),
a3) einem Widerstandselement (4; 13) aus einem Widerstandsmaterial, wobei das Widerstandselement (4; 13) in Stromrichtung zwischen den beiden Anschlussteile angeordnet ist und von dem Strom durchflossen wird,
a4) einem ersten Paar von Spannungsmesskontakten (7; 14) zur Messung der über dem Widerstandselement (4; 13) abfallenden Spannung, wobei der eine Spannungsmesskontakt (7) das erste Anschlussteil (2) elektrisch kontaktiert, während der andere Spannungsmesskontakt (7) das zweite Anschlussteil (3) elektrisch kontaktiert, und mit
a5) einem zweiten Paar von Spannungsmesskontakten (7; 14) zur Messung der über dem Widerstandselement (4; 13) abfallenden Spannung aufweist, wobei der eine Spannungsmesskontakt (7) das erste Anschlussteil (2) elektrisch kontaktiert, während der andere Spannungsmesskontakt (7) das zweite Anschlussteil (3) elektrisch kontaktiert,
b) einer Auswertungseinheit, die mit den Paaren von Spannungsmesskontakten (7; 14) verbunden ist und an den Paaren jeweils einen Spannungsmesswert erfasst und aus den Spannungsmesswerten die über dem Widerstandselement (4; 13) abfallende Spannung ermittelt,
**dadurch gekennzeichnet**,
c) dass die Auswertungseinheit die einzelnen Spannungsmesswerte jeweils mit einem Gewichtungsfaktor gewichtet, und
d) dass die Auswertungeinheit die über dem Widerstandselement (4; 13) abfallende Spannung aus den gewichteten Spannungswerten bestimmt.

2. Messanordnung nach Anspruch 1, **dadurch gekennzeichnet, dass** die Paare von Spannungsmesskontakten (7; 14) bezüglich der Stromflussrichtung in dem Messwiderstand (1; 10) nebeneinander angeordnet sind.

3. Messanordnung nach einem der vorhergehenden Ansprüche, **dadurch gekennzeichnet, dass** die Paare der Spannungsmesskontakte (7; 14) im Wesentlichen äquidistant verteilt angeordnet sind.

4. Messanordnung nach einem der vorhergehenden Ansprüche, **dadurch gekennzeichnet, dass** das Widerstandselement (4; 13) quer zur Stromflussrichtung eine Breite (b) von mindestens 5 mm, 10 mm, 20 mm, 50 mm 100 mm oder 200 mm aufweist.

5. Messanordnung nach einem der vorhergehenden Ansprüche, **dadurch gekennzeichnet, dass** die Anzahl der Paare von Spannungsmesskontakten (7; 14) größer ist als zwei, vier, sechs oder acht.

6. Messanordnung nach einem der vorhergehenden Ansprüche, **dadurch gekennzeichnet,**
a) **dass** der Messwiderstand (1) plattenförmig ist oder
b) **dass** der Messwiderstand (10) ein Koaxialwiderstand ist, wobei die Paare von Spannungsmesskontakten (14) über den Umfang verteilt angeordnet sind.

7. Messanordnung nach eine der vorhergehenden Ansprüche, **dadurch gekennzeichnet,**
a) **dass** der Messwiderstand (1; 10) an mindestens einem der Paare von Spannungsmesskontakten (7; 14) ein kapazitives Verhalten zeigt, und
b) **dass** der Messwiderstand (1; 10) an mindestens einem der Paare von Spannungsmesskontakten (7; 14) ein induktives Verhalten zeigt.

8. Messverfahren, insbesondere zur Strommessung gemäß der Vierleitertechnik, insbesondere mit einem Messwiderstand (1; 10) nach einem der vorhergehenden Ansprüche, mit den folgenden Schritten:
a) Einleiten eines zu messenden Stroms in einen Messwiderstand (1; 10), so dass der Strom durch ein Widerstandselement (4; 13) in dem Messwiderstand (1; 10) fließt,
b) Ausleiten des Stroms aus dem Messwiderstand (1; 10) und
c) Ermitteln der Spannung, die über dem Widerstandselement (4; 13) des Messwiderstands (1; 10) abfällt, wenn der Strom durch das Widerstandselement (4; 13) fließt, wobei die Spannung an einem ersten Paar von Spannungsmesskontakten (7; 14) gemessen wird,
d) wobei an mehreren Paaren von Spannungsmesskontakten (7; 14) jeweils Spannungsmesswerte der über dem Widerstandselement (4; 13) abfallenden Spannung gemessen werden,
e) wobei die über dem Widerstandselement (4; 13) abfallende Spannung aus den einzelnen Spannungsmesswerten an den Paaren von Spannungsmesskontakten (7; 14) ermittelt wird,
**gekennzeichnet durch** folgende Schritte:
f) Gewichten der einzelnen Spannungsmesswerte jeweils mit einem Gewichtungsfaktor, und
g) Bestimmen der über dem Widerstandselement (4; 13) abfallenden Spannung aus den gewichteten Spannungsmesswerten.

9. Messverfahren nach Anspruch 8, **gekennzeichnet durch** folgenden Schritt:
Kalibrieren der Gewichtungsfaktoren in einem Kalibrierungsvorgang.

10. Messverfahren nach Anspruch 9, **gekennzeichnet durch** folgende Schritte:
a) Ermitteln von mindestens einem Messparameter, der einen Einfluss hat auf Inhomogenitäten des Stroms in dem Widerstandselement (4; 13), und
b) Bestimmen der Gewichtungsfaktoren in Abhängigkeit von dem mindestens einen Messparameter.

11. Messverfahren nach Anspruch 10, **dadurch gekennzeichnet, dass** der Messparameter mindestens eine der folgenden Größen umfasst:
a) Frequenz des Stroms,
b) Temperatur der Umgebung oder des Messwiderstands,
c) Größe und Richtung eines äußeren Magnetfelds, in dem die Messung erfolgt,
d) Strom durch den Messwiderstand,
e) Spannung über den Spannungsmesskontakten.

12. Messverfahren nach einem der Ansprüche 8 bis 11, **dadurch gekennzeichnet, dass** die Spannungsmesswerte an den einzelnen Paaren der Spannungsmesskontakte (7; 14) synchron gemessen werden.

13. Messverfahren nach einem der Ansprüche 8 bis 12, **dadurch gekennzeichnet, dass** Spannungsmesswerte an den einzelnen Paaren der Spannungsmesskontakte (7; 14) mit einer Abtastrate von mindestens 100 Hz, 500 Hz, 1 kHz, 2 kHz oder mindestens 4 kHz gemessen werden.

14. Messverfahren nach einem der Ansprüche 9 bis 13, **gekennzeichnet durch** folgende Schritte:
a) Berechnen eines einfachen oder gewichteten Mittelwerts der Spannungsmesswerte,
b) Berechnen der über dem Widerstandselement (4; 13) abfallenden Spannung aus dem Mittelwert der Spannungsmesswerte.

15. Messverfahren nach einem der Ansprüche 8 bis 13, **dadurch gekennzeichnet,**
a) **dass** die analogen Spannungsmesswerte in digitalisierte Spannungsmesswerte umgewandelt werden, und/oder
b) **dass** die einfache oder gewichtete Mittelwertbildung auf der Grundlage der analogen Spannungsmesswerte oder auf der Grundlage der digitalisierten Spannungsmesswerte erfolgt.

## Claims

1. Measuring arrangement with
a) a measuring resistor (1; 10) comprising
a1) a first connection part (2) made of a conductive material for conducting a current into the measuring resistor (1; 10),
a2) a second connection part (3) made of a conductive material for conducting the current out of the measuring resistor (1; 10),
a3) a resistor element (4; 13) made of a resistive material, wherein the resistor element (4; 13) is arranged in the current direction between the two connection parts, and through which resistive material the current flows,
a4) a first pair of voltage-measuring contacts (7; 14) for measuring the voltage drop across the resistor element (4; 13), wherein the one voltage-measuring contact (7) is electrically connected to the first connection part (2), whereas the other voltage-measuring contact (7) is electrically connected to the second connection part (3), and with
a5) a second pair of voltage-measuring contacts (7; 14) for measuring the voltage drop across the resistor element (4; 13), wherein the one voltage-measuring contact (7) is electrically connected to the first connection part (2), whereas the other voltage-measuring contact (7) is electrically connected to the second connection part (3),
b) an evaluation unit (15), which is connected to the pairs of voltage-measuring contacts (7; 14) and acquires the measured voltage values, and determines from the measured voltage values the voltage drop across the resistor element (4; 13),
**characterized in that**
c) the evaluation unit (15) weights the individual measured voltage values with a weighting factor, and
d) the evaluation unit (15) determines the voltage drop across the resistor element (4; 13) from the weighted measured voltage values.

2. Measuring arrangement according to claim 1, **characterized in that** the pairs of voltage-measuring contacts (7; 14) are arranged in the measuring resistor (1; 10) side by side with respect to the direction of current flow.

3. Measuring arrangement according to any of the preceding claims, **characterized in that** the pairs of voltage-measuring contacts (7; 14) are arranged in a substantially equidistant distribution.

4. Measuring arrangement according to any of the preceding claims, **characterized in that** the resistor element (4; 14) has a width (b) across the direction of current flow of at least 5 mm, 10 mm, 20 mm, 50 mm 100 mm or 200 mm.

5. Measuring arrangement according to any of the preceding claims, **characterized in that** the number of pairs of voltage-measuring contacts (7; 14) is greater than two, four, six or eight.

6. Measuring arrangement according to any of the preceding claims, **characterized in that**
a) the measuring resistor (1) is plate-shaped, or
b) the measuring resistor (10) is a coaxial resistor, wherein the pairs of voltage-measuring contacts (14) are distributed around the circumference.

7. Measuring arrangement according to any of the preceding claims, **characterized in that**
a) the measuring resistor (1; 10) exhibits a capacitive behavior at least at one of the pairs of voltage-measuring contacts (7; 14), and
b) the measuring resistor (1; 10) exhibits an inductive behavior at least at one of the pairs of voltage-measuring contacts (7; 14).

8. A measuring method, in particular for measuring current by means of the four-wire technique, in particular using a measuring resistor (1; 10) according to any of the preceding claims, comprising the following steps:
a) conducting a current to be measured into a measuring resistor (1; 10), so that the current flows through a resistor element (4; 13) in the measuring resistor (1; 10),
b) conducting the current out of the measuring resistor (1; 10), and
c) determining the voltage drop across the resistor element (4; 13) of the measuring resistor (1; 10) when the current is flowing through the resistor element (4; 13), which voltage is measured at a first pair of voltage-measuring contacts (7; 14),
d) wherein measured voltage values of the voltage drop across the resistor element (4; 13) are measured at each of a plurality of pairs of voltage-measuring contacts (7; 14),
e) wherein the voltage drop across the resistor element (4; 13) is determined from the individual measured voltage values at the pairs of voltage-measuring contacts (7; 14),
**characterized by** the following steps:
f) weighting each of the individual measured voltage values with a weighting factor, and
g) determining the voltage drop across the resistor element (4; 13) from the weighted measured voltage values, and/or

9. The measuring method according to claim 8, **characterized by** the following step:
calibrating the weighting factors in a calibration process.

10. The measuring method according to claim 9, **characterized by** the following steps:
a) determining at least one measurement parameter that has an effect on inhomogeneities in the current in the resistor element (4; 13), and
b) determining the weighting factors according to the at least one measurement parameter.

11. The measuring method according to claim 10, **characterized in that** the measurement parameter comprises at least one of the following variables:
a) frequency of the current,
b) ambient temperature or temperature of the measuring resistor,
c) magnitude and direction of an external magnetic field in which the measurement is taking place,
d) current through the measuring resistor,
e) voltage across the voltage-measuring contacts.

12. The measuring method according to any of claims 8 to 11, **characterized in that** the measured voltage values are measured synchronously at the individual pairs of voltage-measuring contacts (7; 14).

13. The measuring method according to any of claims 8 to 12, **characterized in that** measured voltage values are measured at the individual pairs of voltage-measuring contacts (7; 14) at a sampling rate of at least 100 Hz, 500 Hz, 1 kHz, 2 kHz or at least 4 kHz.

14. The measuring method according to any of claims 8 to 13, **characterized by** the following steps:
a) calculating a simple or weighted average of the measured voltage values,
b) calculating the voltage drop across the resistor element (4; 13) from the average of the measured voltage values.

15. The measuring method according to any of claims 8 to 13, **characterized in that**
a) the analog measured voltage values are converted into digitized measured voltage values, and/or
b) the simple or weighted averaging is performed on the basis of the analog measured voltage values or on the basis of the digitized measured voltage values.

## Revendications

1. Ensemble de mesure avec
a) une résistance de mesure (1 ; 10) avec
a1) une première partie de raccordement (2) composée d'un matériau conducteur servant à acheminer un courant dans la résistance de mesure (1 ; 10),
a2) une deuxième partie de raccordement (3) composée du matériau conducteur servant à acheminer le courant hors de la résistance de mesure (1 ; 10),
a3) un élément de résistance (4 ; 13) composé d'un matériau de résistance, dans lequel l'élément de résistance (4 ; 13) est disposé dans la direction du courant entre les deux parties de raccordement et est traversé par le courant,
a4) une première paire de contacts de mesure de tension (7 ; 14) servant à mesurer la tension chutant en passant par l'élément de résistance (4 ; 13), dans lequel l'un contact de mesure de tension(7) établit un contact électrique avec la première partie de raccordement (2), tandis que l'autre contact de mesure de tension (7) établit un contact électrique avec la deuxième partie de raccordement (3), et avec
a5) une deuxième paire de contacts de mesure de tension (7 ; 14) servant à mesurer la tension chutant en passant par l'élément de résistance (4 ; 13), dans lequel l'un contact de mesure de tension(7) établit un contact électrique avec la première partie de raccordement (2), tandis que l'autre contact de mesure de tension (7) établit un contact électrique avec la deuxième partie de raccordement (3),
b) une unité d'analyse, qui est reliée aux paires de contacts de mesure de tension (7 ; 14) et qui détecte au niveau des paires respectivement une valeur de mesure de tension et qui détermine à partir des valeurs de mesure de tension la tension chutant en passant par l'élément de résistance (4 ; 13),
**caractérisé en ce**
c) **que** l'unité d'analyse pondère les diverses valeurs de mesure de tension respectivement avec un facteur de pondération, et
d) **que** l'unité d'analyse définit à partir des valeurs de tension pondérées la tension chutant en passant par l'élément de résistance (4 ; 13).

2. Ensemble de mesure selon la revendication 1, **caractérisée en ce que** les paires de contacts de mesure de tension (7 ; 14) sont disposées les unes à côté des autres par rapport à la direction du flux de courant dans la résistance de mesure (1 ; 10).

3. Ensemble de mesure selon l'une quelconque des revendications précédentes, **caractérisée en ce que** les paires des contacts de mesure de tension (7 ; 14) sont disposées selon une répartition sensiblement équidistante.

4. Ensemble de mesure selon l'une quelconque des revendications précédentes, **caractérisée en ce que** l'élément de résistance (4 ; 13) présente, de manière transversale par rapport à la direction de flux de courant, une largeur (b) d'au moins 5 mm, 10 mm, 20 mm, 50 mm, 100 mm ou 200 mm.

5. Ensemble de mesure selon l'une quelconque des revendications précédentes, **caractérisée en ce que** le nombre des paires de contacts de mesure de tension (7 ; 14) est supérieur à deux, quatre, six ou huit.

6. Ensemble de mesure selon l'une quelconque des revendications précédentes, **caractérisée en ce**
a) **que** la résistance de mesure (1) présente une forme de plaque, ou
b) **que** la résistance de mesure (10) est une résistance coaxiale, dans laquelle les paires de contacts de mesure de pression (14) sont disposées de manière répartie sur la périphérie.

7. Ensemble de mesure selon l'une quelconque des revendications précédentes, caractérisée en ce
a) que la résistance de mesure (1 ; 10) indique, au niveau au moins de l'une des paires de contact de mesure de tension (7 ; 14), un comportement capacitif, et
b) que la résistance de mesure (1 ; 10) affiche, au niveau au moins d'une des paires de contacts de mesure de tension (7 ; 14), un comportement inductif.

8. Procédé de mesure, en particulier servant à la mesure de tension selon la technique à quatre conducteurs, en particulier à l'aide d'une résistance de mesure (1 ; 10) selon l'une quelconque des revendications précédentes, avec les étapes suivantes consistant à :
a) acheminer un courant à mesurer dans une résistance de mesure (1 ; 10) de sorte que le courant s'écoule à travers un élément de résistance (4 ; 13) dans la résistance de mesure (1 ; 10),
b) acheminer le courant hors de la résistance de mesure (1 ; 10), et
c) déterminer la tension, qui chute en passant par l'élément de résistance (4 ; 13) de la résistance de mesure (1 ; 10) lorsque le courant s'écoule à travers l'élément de résistance (4 ; 13), dans lequel la tension est mesurée au niveau d'une première paire de contacts de mesure de tension (7 ; 14),
d) dans lequel respectivement des valeurs de mesure de tension de la tension chutant en passant par l'élément de résistance (4 ; 13) sont mesurées au niveau de plusieurs paires de contacts de mesure de tension (7 ; 14),
e) dans lequel la tension chutant en passant par l'élément de résistance (4 ; 13) est déterminée à partir des diverses valeurs de mesure de tension au niveau des paires de contacts de mesure de tension (7 ; 14),
**caractérisé par** les étapes suivantes consistant à :
f) pondérer les diverses valeurs de mesure de tension respectivement à l'aide d'un facteur de pondération, et
g) définir la tension chutant en passant par l'élément de résistance (4 ; 13) à partir des valeurs de mesure de tension pondérées.

9. Procédé de mesure selon la revendication 8, **caractérisé par** l'étape suivante consistant à :
calibrer les facteurs de pondération lors d'une opération de calibrage.

10. Procédé de mesure selon la revendication 9, **caractérisé par** les étapes suivantes consistant à :
a) déterminer au moins un paramètre de mesure, qui exerce une incidence sur des inhomogénéités du courant dans l'élément de résistance (4 ; 13), et
b) définir les facteurs de pondération en fonction de l'au moins un paramètre de mesure.

11. Procédé de mesure selon la revendication 10, **caractérisé en ce que** le paramètre de mesure comprend au moins unes des grandeurs suivantes :
a) la fréquence du courant,
b) la température de l'environnement ou de la résistance de mesure,
c) la grandeur et la direction d'un champ magnétique extérieur dans lequel la mesure est effectuée,
d) le courant à travers la résistance de mesure,
e) la tension passant par les contacts de mesure de tension.

12. Procédé de mesure selon l'une quelconque des revendications 8 à 11, **caractérisé en ce que** les valeurs de mesure de tension sont mesurées de manière synchrone au niveau des diverses paires des contacts de mesure de tension (7 ; 14).

13. Procédé de mesure selon l'une quelconque des revendications 8 à 12, **caractérisé en ce que** des valeurs de mesure de tension sont mesurées au niveau des diverses paires des contacts de mesure de tension (7 ; 14) à une vitesse d'échantillonnage d'au moins 100 Hz, 500 Hz, 1 kHz, 2 kHz ou d'au moins 4 kHz.

14. Procédé de mesure selon l'une quelconque des revendications 9 à 13, **caractérisé par** les étapes suivantes consistant à :
a) calculer une valeur moyenne simple ou pondérée des valeurs de mesure de tension,
b) calculer la tension chutant en passant par l'élément de résistance (4 ; 13) à partir de la valeur moyenne des valeurs de mesure de tension.

15. Procédé de mesure selon l'une quelconque des revendications 8 à 13, **caractérisé en ce**
a) **que** les valeurs de mesure de tension analogiques sont converties en des valeurs de mesure de tension numérisées, et/ou
b) **que** l'obtention simple ou par pondération de la valeur moyenne a lieu sur la base des valeurs de mesure de tension analogiques ou sur la base des valeurs de mesure de tension numérisées.
